# EUROPÄISCHE PATENTSCHRIFT

(11) **EP 0 861 505 B1**
(45) Veröffentlichungstag und Bekanntmachung des Hinweises auf die Patenterteilung: **04.07.2001**
(21) Anmeldenummer: 96945862.9
(22) Anmeldetag: 06.11.1996
(51) Int. Cl.: H01L 33/00, H01S 5/347

(54) **OPTOELEKTRONISCHES BAUELEMENT IN II-VI-HALBLEITERMATERIAL**
OPTO-ELECTRONIC COMPONENT MADE FROM II-VI SEMICONDUCTOR MATERIAL
COMPOSANT OPTOELECTRONIQUE REALISE DANS UN MATERIAU SEMI-CONDUCTEUR II-VI

(30) Priorität: 13.11.1995 DE 19542241
(43) Veröffentlichungstag der Anmeldung: 02.09.1998
(73) Patentinhaber: Osram Opto Semiconductors GmbH & Co. OHG, 93049 Regensburg (DE)
(72) Erfinder: FISCHER, Frank, D-97074 Würzburg (DE); LUGAUER, Hans-Jürgen, D-97218 Gerbrunn (DE); LITZ, Thomas, D-97074 Würzburg (DE); LANDWEHR, Gottfried, D-97074 Würzburg (DE); WAAG, Andreas, D-97076 Würzburg (DE)
(74) Vertreter: Fischer, Volker, Dipl.-Ing.
(86) Internationale Anmeldenummer: DE9602110
(87) Internationale Veröffentlichungsnummer: WO9718592

(56) Entgegenhaltungen:
- EP-A- 0 556 461
- WO-A-94/15369
- US-A- 5 198 690
- PATENT ABSTRACTS OF JAPAN vol. 095, no. 006, 31.Juli 1995 & JP 07 066494 A (SONY CORP), 10.März 1995, in der Anmeldung erwähnt
- PATENT ABSTRACTS OF JAPAN vol. 096, no. 001, 31.Januar 1996 & JP 07 232999 A (KOBE STEEL LTD), 5.September 1995,
- PATENT ABSTRACTS OF JAPAN vol. 18, no. 464 (E-1598), 29.August 1994 & JP 06 152061 A (SONY CORP), 31.Mai 1994,
- PATENT ABSTRACTS OF JAPAN vol. 95, no. 11, 26.Dezember 1995 & JP 07 211988 A (FUJITSU LTD), 11.August 1995,
- PATENT ABSTRACTS OF JAPAN vol. 096, no. 010, 31.Oktober 1996 & JP 08 148765 A (NEC CORP)

## Beschreibung

In der Veröffentlichung von A. Ishibashi: "II-VI Blue-Green Laser Diodes" in IEEE Journal of Selected Topics in Quantum Electronics, 1, 741 bis 748 (1995) ist eine Übersicht gegeben über die Verwendung von II-VI-Halbleitermaterial zur Herstellung von Laserdioden, die blaues oder grünes Licht emittieren. Als Material wird angegeben ZnMgSSe, ZnCdSe bzw. ZnSe und ZnTe. Es wird auch eine MQW-Struktur aus ZnTe/ZnSe erwähnt. In der JP-OS 7-66 494 und der US 5,268,918 sind berylliumhaltige Halbleiterzusammensetzungen für die Herstellung blau oder grün emittierender Laserdioden beschrieben. In der US 5,422,902 und in den Veröffentlichungen von P.M. Mensz: "BeTe/ZnSe graded band gap ohmic contacts to p-ZnSe" in Appl. Phys. Lett. 64, 2148 bis 2150 (1994) und von R. G. Dandrea et al.: "Design of ohmic contacts to p-ZnSe" in Appl. Phys. Lett. 64, 2145 bis 2147 (1994) ist die Verwendung einer gradierten Schichtfolge aus BeTe und ZnSe für die Herstellung von Kontaktschichten zwischen einer aktiven Schicht und einem metallischen Anschlußkontakt beschrieben.

In der WO 94/15369 sind lichtemittierende Halbleiterbauelemente in II-IV-Halbleitermaterial beschrieben. Auf einem Substrat aus III-V-Halbleitermaterial vorhandene Schichtstrukturen, die eine für Strahlungserzeugung vorgesehene aktive Schicht und Barriereschichten umfassen, enthalten ternäre und quaternäre Mischkristallzusammensetzungen aus II-VI-Halbleitermaterial, wie z. B. ZnCdSe, ZnBeSe, ZnBeTe, ZnCdSSe und ZnCdSTe. Außerdem ist eine Kontaktschicht mit Gitteranpassung an das Substrat oder eine Pufferschicht und mit einer gradierten Materialzusammensetzung zur Anpassung der Energiebandlücke beschrieben, bei der abwechselnd Schichten aus unterschiedlichen II-VI-Materialien verwendet werden, wie z. B.

ZnTe, ZnSTe, ZnBeTe, ZnCdTe bzw. ZnSe, ZnSSe, ZnBeTe, ZnCdSe und ZnCdSSe. In der US 5,198,690 sind lichtemittierende Bauelemente in II-IV-Halbleitermaterial angegeben, bei denen auf CdBeTe, HgBeTe, GaAs, GaP, Si, Ge, ZnSe, ZnS oder ZnSSe eine Pufferschicht aus ZnSSe sowie eine Schicht aus p-dotiertem CdBeTe, CdBeSTe, ZnBeTe, ZnCdBeTe, ZnBeSTe oder ZnBeSeTe und eine n-dotierte Schicht, deren Mischkristallzusammensetzung Zink enthält, wie z. B. ZnS, ZnTe, ZnSe, ZnCdS, ZnCdTe, ZnSTe, ZnBeS, ZnBeSe, ZnBeTe, ZnMgTe, ZnHgTe oder ZnSeTe epitaktisch aufgewachsen sind. Als n-dotierte Schicht wird vor allem ZnSe oder ZnS angegeben, als p-dotierte Schicht ZnBeTe oder CdBeTe. Die n-dotierte Schicht kann auch als ZnS/ZnSe-Übergitter ausgebildet sein, um so zusätzliche Eigenschaften einer Pufferschicht zu bieten. Die n-leitend dotierte Schicht ist jeweils vorrangig als strahlungserzeugende Schicht vorgesehen, obwohl Strahlungserzeugung in der p-leitend dotierten Schicht nicht ausgeschlossen ist.

Die in den genannten Veröffentlichungen beschriebenen Strukturen und Materialien haben verschiedene Nachteile, die die Verwendung für Laserdioden beeinträchtigen. Bei der Verwendung von ZnSe treten die Schwierigkeiten auf, daß das Aufwachsen derartiger Schichten auf einem GaAs-Substrat gestört erfolgt, daß ein schlechter Transport von Ladungsträgern über die Grenzfläche zwischen dem II-VI-Halbleiter und dem III-V-Halbleiter erfolgt und daß z. B. wegen des Unterschiedes in den Gitterkonstanten keine gute Gitteranpassung von ZnTe an GaAs möglich ist. Außerdem läßt sich auf p-leitend dotiertem ZnSe kein guter ohmscher Kontakt zu Metallen herstellen.

Aufgabe der vorliegenden Erfindung ist es, ein verbessertes optoelektronisches Bauelement für Strahlungserzeugung, im grünen und blauen Spektralbereich, anzugeben, das funktionsfähig ist und einfach hergestellt werden kann.

Diese Aufgabe wird mit Bauelementen mit den Merkmalen der Ansprüche 1 und 3 gelöst. Ausgestaltungen ergeben sich aus den jeweiligen abhängigen Ansprüchen.

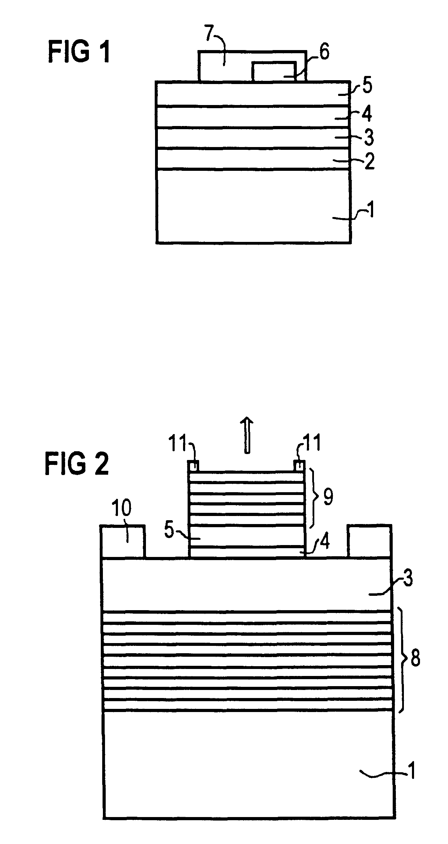

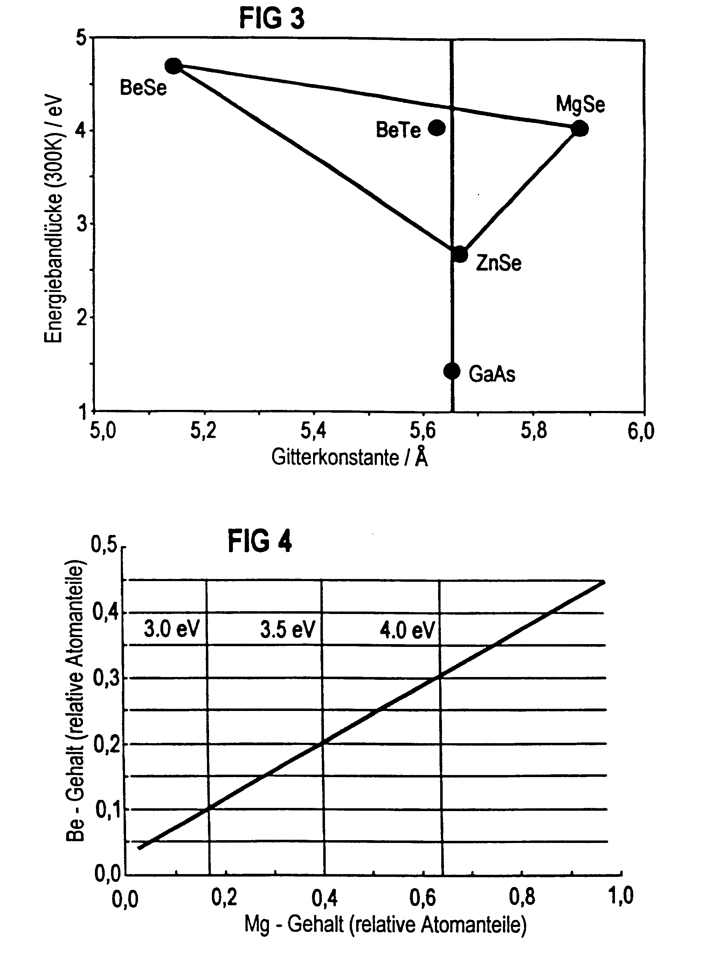

Das erfindungsgemäße optoelektronische Bauelement gemäß den Ansprüchen 1 - 4 verwendet zur Ausbildung von Leuchtdioden oder Laserdioden eine Schichtstruktur aus II-VI-Halbleitermaterial unter Einbeziehung mindestens eines berylliumhaltigen Chalkogenides, worunter ein Berylliumchalkogenid oder eine Mischkristallzusammensetzung auf der Grundlage eines Berylliumchalkogenides zu verstehen ist. Als Chalkogene kommen vorzugsweise Te, Se und S in Frage. Im folgenden bezeichnet daher "berylliumhaltiges Chalkogenid" ein beliebiges, insbesondere ein S, Se oder Te enthaltendes Salz, das als Kation Be enthält oder Be und beliebig viele andere Kationen wie z. B. Mg oder Zn. Bevorzugte Ausführungsformen sehen insbesondere eine Kombination mit ZnSe und mit einem GaAs-Substrat vor. Es können jedoch auch andere Substrate wie z.B. InP, InGaAs, ZnSe, Si, Ge, GaP o.ä. Verwendung finden. Für die aktive Schicht oder Schichtstruktur sowie für Mantelschichten, worunter im folgenden Pufferschichten, (zusätzliche) Barriereschichten (Confinement-Schichten), (auch passive) Wellenleiterschichten, Gitterschichten, Deckschichten und Schichtanteile oder Kombinationen solcher Schichten zu verstehen sind, erscheinen insbesondere BeTe, BeSe, BeS und Mischkristallzusammensetzungen dieser Berylliumchalkogenide mit Halbleitermaterialien wie z. B. ZnSe, ZnS, ZnTe und MgSe geeignet. II-VI-Halbleitermaterial kann im folgenden immer auch speziell ein (weiteres) berylliumhaltiges Chalkogenid bezeichnen. Verschiedene Ausführungsformen werden im folgenden im einzelnen anhand der Figuren 1 bis 4 beschrieben.
- Figuren 1 und 2: zeigen erfindungsgemäße Bauelemente im Querschnitt.
- Figur 3: zeigt ein Diagramm, in dem für wichtige Halbleiterverbindungen die Energiebandlücke über der Gitterkonstanten aufgetragen ist.
- Figur 4: zeigt ein Diagramm, in dem die Energiebandlücke von BeMgZnSe für verschiedene relative Atomanteile von Mg und Be aufgetragen ist.

In Figur 1 ist eine Schichtstruktur gezeichnet, bei der auf einem Substrat 1 eine Übergangsschicht oder Pufferschicht 2, eine untere Barriereschicht 3 (Confinement), eine aktive Schicht 4 und eine obere Barriereschicht 5 aufgewachsen sind. Die unteren und oberen Barriereschichten können unterschiedliche Schichten für das optische und elektrische Confinement enthalten. Zwischen den Barriereschichten und der aktiven Schicht können passive Wellenleiterschichten (nicht eingezeichnet) vorhanden sein. Auf der Oberseite sind als Beispiel ein Aluminium-Kontakt 6 und ein darauf aufgebrachter Ti/Au-Kontakt 7 eingezeichnet. Ein Gegenkontakt, der nicht eingezeichnet ist, befindet sich z. B. auf der Unterseite des Substrates. Das Substrat und die Schichten zwischen dem Substrat und der aktiven Schicht 4 sind z. B. p-leitend dotiert. Die obere Barriereschicht 5 ist z. B. n-leitend dotiert. Die Dotierung kann aber auch umgekehrt vorgenommen sein. Die Barriereschichten 3, 5 sind gemäß einer Ausgestaltung der Erfindung aus berylliumhaltigem Chalkogenid, z. B. BeMgZnSe. Die aktive Schicht kann z. B. ZnSe sein.

Die aktive Schicht ist vorzugsweise eine alternierende Schichtfolge, die eine MQW-Struktur oder (bei entsprechend geringerer Schichtdicke) eine Übergitterstruktur (superlattice) bildet. Eine solche alternierende Schichtfolge wird vorzugsweise aus abwechselnd ZnSe und BeTe oder nach dem derzeitigen Stand der Erprobung noch besser aus abwechselnd ZnCdSe und BeTe gebildet. Mit diesen Materialkombinationen kann die Energiebandlücke zur Festlegung der Wellenlänge der erzeugten Strahlung zwischen 1,8 eV und 2,9 eV eingestellt werden. Die Gesamtheit dieses Bereiches wird durch Verwendung von Übergittern realisierbar. Die Kombination des indirekten Halbleiters BeTe mit einem direkten Halbleiter wie z. B. ZnSe begünstigt die Lichterzeugung, und die Ausgestaltung dieser Kombination als Übergitter erhöht den wegen des nur langsam erfolgenden sogenannten Typ-II-Elektron-Loch-Überganges zwischen BeTe und ZnSe ansonsten geringen Wirkungsgrad. Bei sehr kleinen Schichtdicken in diesem Übergitter durchmischen sich die verwendeten Materialien weitgehend, so daß es zu einer BeZnSeTe-Zusammensetzung kommt, die zumindest bereichsweise in eine quaternäre Legierung oder Mischkristallzusammensetzung übergeht. Mit diesen Übergangsformen als Grenzfall für mögliche Ausführungsformen erhält man eine sehr weitgehende Variationsmöglichkeit des realisierbaren Wellenlängenbereiches.

Für die aktive Zone kann auch BeₓZn_{y}Cd_{1-x-y}Se oder entsprechend BeₓZn_{y}Cd_{1-x-y}S vorteilhaft eingesetzt werden. Für eine Erhöhung der Lebensdauer des Bauelementes kann es von Vorteil sein, wenn dabei ein hoher Berylliumgehalt gewählt wird, was aufgrund der Härte der berylliumhaltigen Chalkogenide günstig ist. Der Berylliumanteil beträgt hier vorzugsweise mindestens 3 Atomprozent (x ≥ 0,03), was eine Härtung, d. h. Stabilisierung des Kristallgitters bewirkt. Der Zinkanteil kann gleich null sein (y = 0). Durch die Wahl der Kationenanteile x und y ist es möglich, die Gitterkonstante der aktiven Schicht an die Gitterkonstante einer Begrenzungsschicht bzw. des Substrates anzupassen. Alternativ gestatten diese Materialkombinationen, die aktive Schicht oder die aktiven Schichten mit einer Zug- oder Druckspannung zu versehen (z. B. gegenüber der Gitteranpassung an ein GaAs-Substrat verspannt). Auf diese Weise ist es möglich, die elektronische Bandstruktur der aktiven Schicht gezielt zu modifizieren im Hinblick auf eine optimale Funktion und Lebensdauer des Bauelementes. Eine derartige umfassende Variationsmöglichkeit ist bei Laserdioden mit Deckschichten aus quaternären Legierungen der Zusammensetzung ZnₓMg₁₋ₓS_{y}Se_{1-y} und einer aktiven Schicht aus ZnₓCd₁₋ₓSe nicht möglich, da die aktive Schicht dort stets druckverspannt ist.

ZnSe oder ZnCdSe kann in dem beschriebenen Beispiel durch ein anderes II-VI-Halbleitermaterial ersetzt sein. Für die Schichten aus berylliumhaltigem Chalkogenid kommen vorrangig BeTe, BeSe und Mischkristallzusammensetzungen dieser Berylliumchalkogenide in Frage. In der aktiven Schicht können ein oder mehrere Quantentöpfe (quantum wells) jeweils durch eine Schicht aus berylliumhaltigem Chalkogenid ausgebildet sein. Eine berylliumhaltige aktive Schicht kann auch mit nicht berylliumhaltigen Barriereschichten als Begrenzungen kombiniert werden. Ein Berylliumchalkogenid oder verschiedene Berylliumchalkogenide kann bzw. können z.B. in der aktiven Schicht oder im Wellenleiter, in Barriereschichten oder in sonstigen Mantelschichten einzeln oder gemeinsam eingesetzt werden. Eine weitere vorteilhafte Ausführungsform sieht eine berylliumchalkogenidhaltige Schicht als Mantelschicht oder als Pufferschicht zwischen einem Substrat und einer die aktive Schicht umfassenden Schichtstruktur vor, die in einem Materialsystem eines III-V-Halbleiters ausgebildet ist. Eine solche Ausführung ist insbesondere für weitgehend integrierte optoelektronische Systeme, wie sie z. B. sehr gut auf Siliziumsubstraten angeordnet werden können, geeignet. Hierbei kann eine Struktur eines herkömmlichen optoelektronischen Bauelementes aus III-V-Halbleitermaterialien auf einer Mantel- oder Pufferschicht aus einem berylliumhaltigen Chalkogenid, vorzugsweise z. B. BeTe, auf einem Si-Substrat angeordnet werden.

Die Übergangsschicht oder Pufferschicht 2, die bei der Ausführungsform gemäß Figur 1 im Prinzip entfallen kann, hat bei Verwendung von Berylliumchalkogeniden besondere Vorteile, weil damit das Halbleitermaterial des Substrates 1 an die weiteren aufgewachsenen Schichten angepaßt werden kann. Für diese Pufferschicht eignet sich insbesondere BeTe. Diese Zusammensetzung wächst auf einem Substrat aus GaAs anfänglich wesentlich besser als ZnSe, was eine der üblichen Halbleiterkomponenten für blau strahlende LEDs ist. Die Pufferschicht aus BeTe auf dem Substrat ist z.B. 50 nm dick. Die verwendeten Substrattemperaturen liegen dabei zwischen 200 °C und 400 °C.

Statt einer einzelnen BeTe-Schicht als Pufferschicht oder zusätzlich dazu kann auch ein BeTe/ZnSe-Übergitter (superlattice) oder ein BeTe/ZnCdSe-Übergitter verwendet werden; bei einem verspannten Übergitter wechseln sich Zug- und Druckspannungen ab. Hierbei haben die vorgeschlagenen Materialien den besonderen Vorteil, daß die mittlere Gitterkonstante des Übergitters über das Verhältnis der beiden Schichtdicken sehr genau z.B. an die Gitterkonstante des Substrates angepaßt werden kann. Hierdurch können auch sehr dicke Pufferschichten mit hoher Qualität einfach hergestellt werden. Der Einsatz solcher Übergitter führt außerdem zur Einschränkung von Wanderungen von Versetzungen. Derartige Wanderungen von Versetzungen in die aktive Zone können die Lebensdauer des Bauelementes verringern. Die Verwendung einer Pufferschicht aus BeTe oder einer Zusammensetzung mit BeTe bringt den zusätzlichen Vorteil, daß an der Grenzfläche zwischen einem Substrat aus III-V-Halbleitermaterial und einer nachfolgenden Schicht aus II-VI-Halbleitermaterial kein hoher elektrischer Übergangswiderstand auftritt. Wenn die Pufferschicht ganz oder zumindest in einem oberen, der aktiven Schicht zugewandten Anteil eine berylliumhaltige quaternäre Zusammensetzung ist, z. B. eine BeTeZnSe-Mischkristallzusammensetzung, kann ein gradueller Übergang in der Zusammensetzung für eine geeignete Anpassung der elektronischen Bänder zwischen dem Halbleitermaterial darüber und darunter sorgen.

Wenn die Pufferschicht 2 oder ein Anteil davon in einer nicht periodischen Folge von BeTe-Schichten und ZnSe-Schichten oder ZnCdSe-Schichten ein Pseudo-Grading bildet, bei dem das BeTe/ZnSe- oder BeTe/ZnCdSe-Übergitter an die Stelle einer quaternären Legierung mit kontinuierlich variierenden Anteilen tritt, kann ein niedriger ohmscher Kontakt auf p-leitend dotiertem ZnSe auf relativ einfache Weise realisiert werden. Ein Pseudo-Grading ist eine Vielfach-Schichtstruktur, bei der elektronische Bänder und Gitterkonstanten zwischen zwei Materialien angepaßt werden können. Diese Struktur wird gebildet aus einer Folge von Schichten, die abwechselnd aus einem Material A und einem Material B bestehen, bei denen die Dicke der Schichten aus Material A in einer Richtung stets abnimmt und die Dicke der Schichten aus Material B in dieser Richtung stets zunimmt. Die gesamte Dicke aller dieser Schichten muß genügend klein sein, um einen effizienten Stromtransport zu gewährleisten. Das hängt im jeweiligen Fall von den Materialien A und B ab.

Bei einem bevorzugten Ausführungsbeispiel des erfindungsgemäßen Bauelementes befindet sich auf einem Substrat zunächst eine z. B. 50 nm dicke Pufferschicht z. B. aus BeTe (die auch weggelassen sein kann) und darauf (oder direkt auf dem Substrat) ein Pseudo-Grading aus einer Folge von einander abwechselnden BeTe-Schichten und ZnSe- oder ZnCdSe-Schichten, das die elektronischen Bänder und eventuell auch die Gitterkonstanten zwischen den Schichten darüber und darunter anpaßt. Bei diesem Pseudo-Grading wird die Dicke der BeTe-Schichten in Richtung zur aktiven Schicht hin in kleinen Schritten von z.B. 1 Monolage verkleinert und die Dicke der Zn(Cd)Se-Schichten in kleinen Schritten von z.B. 1 Monolage vergrößert. Die Dicke der Einzelschichten muß dabei unter 50 nm liegen. Besonders geeignet sind Schichtdicken unterhalb von 20 nm. Beginnend mit z. B. 3.7 nm BeTe und 0.3 nm ZnSe oder ZnCdSe werden die Schichtdicken verändert bis hin zu 0.3 nm BeTe und 3.7 nm Zn(Cd)Se. Dies würde z.B. ein Pseudo-Grading zwischen BeTe und ZnSe bzw. ZnCdSe erzeugen. Statt BeTe und ZnSe oder ZnCdSe können z. B. zwei verschiedene berylliumhaltige II-VI-Halbleitermaterialien, z. B. ternäre oder quaternäre Mischkristallzusammensetzungen mit Be, vorhanden sein.

Die angegebenen Ausführungen einer Mantelschicht, hier speziell am Beispiel einer Pufferschicht beschrieben, können auch miteinander kombiniert werden. Insbesondere können Pseudo-Grading und Übergitter miteinander kombiniert werden. Es kann z. B. ein Übergitter, das durch eine alternierende Folge von Schichten stets gleicher Dicke und unterschiedlicher Materialien gebildet wird, zwischen einer Pufferschicht (z. B. aus BeTe) und einem Pseudo-Grading, wie es oben beschrieben ist, angeordnet sein. Auch bei einer Laserdiode, die im übrigen aus den herkömmlichen Materialien ZnSe und ZnMgSSe oder aus III-V-Halbleitermaterial besteht, kann mit einer berylliumhaltigen Schicht oder Schichtstruktur zwischen einem Substrat aus III-V-Halbleitermaterial oder aus Silizium und den anschließend aufgewachsenen Schichten aus II-VI-Halbleitermaterialien oder aus III-V-Halbleitermaterialien, die die aktive Schicht umfassen, eine wesentliche Verbesserung und auch eine Vereinfachung bei der Herstellung erreicht werden.

Eine weitere Ausführungsform weist als Barriereschichten 3, 5 Doppel- oder Mehrfachschichten mit Schichtanteilen aus einem Berylliumchalkogenid, z. B. Schichtfolgen aus BeTe und ZnSe, auf. Der direkte Energiebandabstand von BeTe wurde zu 4,05 eV bestimmt. Ältere Zahlenangaben sind damit korrigiert. Unter Verwendung des neuen Wertes erhält man für den Übergang zwischen BeTe und ZnSe einen Sprung im Leitungsband am Gamma-Punkt von etwa 2,1 eV. Da das epitaktische Wachstum dieser Verbindungen zu sehr glatten Grenzflächen führt, können damit Doppel- oder Mehrfachschichten als Barriereschichten (Confinement-Schichten) hergestellt werden. Derartige Strukturen können mit BeTe/ZnSe oder BeTe/ZnCdSe auch als MQW-Strukturen realisiert werden. Solche MQW-Strukturen können z. B. auch zur Herstellung von ohmschen Kontakten auf p-leitend dotiertem ZnSe verwendet werden; das kann in entsprechender Weise erfolgen, wie in der eingangs zitierten Veröffentlichung von Ishibashi für ZnSe und ZnTe angegeben ist.

Bei der Ausführungsform, die in Figur 2 dargestellt ist, befinden sich auf einem Substrat 1 eine Schichtfolge als untere Gitterstruktur 8, eine untere Barriereschicht 3 (Confinement-Schicht), eine aktive Schicht 4, eine obere Barriereschicht 5 und eine Schichtfolge als obere Gitterstruktur 9. Bei diesem Ausführungsbeispiel sind die aktive Schicht 4 und die darauf aufgewachsenen Schichten als Mesa strukturiert. Die untere Barriereschicht 3 ist z. B. n-leitend dotiert und besteht z. B. aus BeMgZnSe. Der zugehörige n-Kontakt 10 ist in diesem Beispiel rings am Rand der Oberseite aufgebracht. Die obere Barriereschicht 5 ist dann p-leitend, besteht z. B. ebenfalls aus BeMgZnSe und ist mit dem p-Kontakt 11 elektrisch leitend verbunden. Der p-Kontakt 11 kann unmittelbar auf der oberen Barriereschicht 5 aufgebracht sein oder durch die obere Gitterstruktur 9, die dann ebenfalls leitend dotiert ist, mit der oberen Barriereschicht 5 leitend verbunden sein. Der p-Kontakt 11 ist im Beispiel der Figur 2 ringförmig am oberen Rand der Mesa aufgebracht, so daß in dem Inneren dieses Metallringes die in der aktiven Schicht 4 erzeugte Strahlung in Richtung des eingezeichneten Pfeiles nach oben austreten kann. Die aktive Schicht 4 bildet z. B. einen Potentialtopf (Quantentrog, quantum well) aus ZnSe. Für die aktive Schicht 4 und die Barriereschichten 3 und 5 kommen auch andere Zusammensetzungen aus II-VI-Halbleitermaterialien in Frage.

Die für einen vertikalen Laserresonator vorgesehenen Gitterstrukturen 8, 9 bilden einen oberen und einen unteren Bragg-Reflektor. Bei der erfindungsgemäßen Diode sind diese Gitterstrukturen durch Schichtfolgen gebildet, in denen Schichten aus einem Berylliumchalkogenid oder einer Mischkristallzusammensetzung auf der Grundlage eines Berylliumchalkogenides und Schichten aus einem weiteren II-VI-Halbleitermaterial abwechselnd übereinander angeordnet sind. Als dieses weitere II-VI-Halbleitermaterial kommen insbesondere ZnSe und Mischkristallzusammensetzungen von ZnSe mit anderen II-VI-Halbleitermaterialien in Frage. Als Berylliumchalkogenid ist hier insbesondere BeTe geeignet. Bei einem bevorzugten Ausführungsbeispiel sind die Gitterstrukturen Folgen von einander abwechselnden BeTe-Schichten und ZnSe- oder ZnCdSe-Schichten. Wegen des nachgewiesenen direkten Energiebandabstandes von 4,05 eV von BeTe ist der Sprung im Brechungsindex zwischen BeTe und Zn(Cd)Se groß genug, um einen effizienten Bragg-Reflektor mit dieser alternierenden Schichtfolge herstellen zu können. Auch bei dieser Ausführungsform ist es möglich, die untere Gitterstruktur 8 und das Substrat (z. B. GaAs) elektrisch leitend zu dotieren und den entsprechenden Kontakt auf der Unterseite des Substrates aufzubringen. Für die aktive Schicht und die Barriereschichten können auch hier Potentialtöpfe oder MQW-Strukturen aus BeTe und ZnSe oder ZnCdSe eingesetzt werden.

Das erfindungsgemäße Bauelement zeigt, wie Berylliumchalkogenide in verschiedenster Zusammensetzung für die aktive Schicht eines strahlungserzeugenden Bauelementes oder für Mantelschichten eingesetzt werden können. Bevorzugt geeignete Zusammensetzungen sind berylliumhaltige Telluride und berylliumhaltige Selenide. In den angegebenen Beispielen kann BeTe jeweils durch ein passendes alternatives Berylliumchalkogenid ersetzt sein. Blau oder grün strahlende LEDs oder Laserdioden in herkömmlichen II-VI-Halbleitermaterialien, insbesondere auf der Basis von ZnSe, lassen sich ebenfalls erfindungsgemäß in vorteilhafter Weise durch Berylliumchalkogenidschichten modifizieren.

## Patentansprüche

1. Optoelektronisches Bauelement in II-VI-Halbleitermaterial auf einem Substrat (1) mit einer für Strahlungserzeugung vorgesehenen aktiven Schicht (4),
- bei dem die aktive Schicht zwischen Schichten (3, 5) angeordnet ist, die für elektrische Leitfähigkeiten mit zueinander entgegengesetzten Vorzeichen dotiert sind, und
- bei dem Kontakte vorhanden sind, die für elektrischen Anschluß an diese Schichten vorgesehen sind,
**dadurch gekennzeichnet, daß**
- die aktive Schicht durch eine Folge von Schichten wechselnder Zusammensetzung als Potentialtopf mit Übergitter ausgebildet ist und
- in dieser Folge von Schichten jeweils eine Schicht aus BeTe und eine Schicht aus ZnSe oder ZnCdSe aufeinanderfolgen.

2. Bauelement nach Anspruch 1,
bei dem die aktive Schicht zwischen Barriereschichten (3, 5) aus berylliumhaltigem Chalkogenid angeordnet ist.

3. Optoelektronisches Bauelement in II-VI-Halbleitermaterial mit einer für Strahlungserzeugung vorgesehenen aktiven Schicht (4),
- bei dem die aktive Schicht zwischen Schichten (3, 5) angeordnet ist, die für elektrische Leitfähigkeiten mit zueinander entgegengesetzten Vorzeichen dotiert sind, und
- bei dem Kontakte vorhanden sind, die für elektrischen Anschluß an diese Schichten vorgesehen sind,
**dadurch gekennzeichnet, daß**
- die aktive Schicht aus BeZnCdSe oder aus BeZnCdS ist und
- das BeZnCdSe oder BeZnCdS mindestens 3 Atomprozent Beryllium enthält.

4. Bauelement nach einem der Ansprüche 1 bis 3,
auf einem Substrat (1) aus einem Material aus der Gruppe von GaAs, InP, InGaAs, Si, Ge, GaP und ZnSe.

## Claims

1. Optoelectronic component using II-VI semiconductor material on a substrate (1) having an active layer (4) provided for radiation generation,
- in which the active layer is arranged between layers (3, 5) which are doped for electrical conductivities with mutually opposite signs, and
in which there are contacts provided for electrical connection to these layers,
characterized in that
- the active layer is formed by a sequence of layers of alternating composition as a potential well with superlattice, and
- in this sequence of layers, a layer made of BeTe and a layer made of ZnSe or ZnCdSe respectively succeed one another.

2. Component according to Claim 1,
in which the active layer is arranged between barrier layers (3, 5) made of beryllium-containing chalcogenide.

3. Optoelectronic component using II-VI semiconductor material having an active layer (4) provided for radiation generation,
- in which the active layer is arranged between layers (3, 5) which are doped for electrical conductivities with mutually opposite signs, and
in which there are contacts provided for electrical connection to these layers,
characterized in that
- the active layer is made of BeZnCdSe or BeZnCdS, and
- the BeZnCdSe or BeZnCdS contains at least three atom percent of beryllium.

4. Component according to one of Claims 1 to 3, on a substrate (1) made of a material from the group of GaAs, InP, InGaAs, Si, Ge, GaP and ZnSe.

## Revendications

1. Composant optoélectronique en matériau semi-conducteur II-VI sur un substrat (1) ayant une couche (4) active prévue pour la production de rayonnement,
- dans lequel la couche active est interposée entre deux couches (3, 5) qui, pour les conductivités électriques, sont dopées suivant des signes mutuellement opposés, et
- dans lequel il y a des contacts qui sont prévus pour le raccordement électrique à ces couches,
caractérisé en ce que
- la couche active est constituée par une succession de couches de composition alternée servant de puits de potentiel à superstructure et
- dans cette succession de couches se succèdent respectivement une couche en BeTe et une couche en ZnSe ou en ZnCdSe.

2. Composant suivant la revendication 1,
dans lequel la couche active est interposée entre des couches (3, 5) formant barrière en chalcogénure contenant du béryllium.

3. Composant optoélectronique en matériau semi-conducteur II-VI ayant une couche (4) active prévue pour la production de rayonnement,
- dans lequel la couche active est interposée entre deux couches (3, 5) qui, pour les conductivités électriques, sont dopées suivant des signes mutuellement opposés, et
- dans lequel il y a des contacts qui sont prévus pour le raccordement électrique à ces couches,
caractérisé en ce que
- la couche active est en BeZnCdSe ou en BeZnCdS et le BeZnCdSe ou le BeZnCdS contient au moins 3% en atome de béryllium.

4. Composant suivant l'une des revendications 1 à 3 sur un substrat (1) en un matériau choisi dans le groupe comprenant GaAs, InP, InGaAs, Si, Ge, GaP et ZnSe.
